# EUROPÄISCHE PATENTSCHRIFT

(11) **EP 2 369 638 B1**
(45) Veröffentlichungstag und Bekanntmachung des Hinweises auf die Patenterteilung: **23.11.2022**
(21) Anmeldenummer: 11002121.9
(22) Anmeldetag: 15.03.2011
(51) Int. Cl.: H01L 31/042, H01L 31/02

(54) **Photovoltaikanlage mit einer Vorrichtung zur Potentialabsenkung**
Photovoltaic facility with a device to decrease the potential
Installation photovoltaïque dotée d'un dispositif de réduction de potentiel

(30) Priorität: 23.03.2010 DE 102010012294
(43) Veröffentlichungstag der Anmeldung: 28.09.2011
(73) Patentinhaber: Padcon GmbH, 97509 Kolitzheim (DE)
(72) Erfinder: Beck, Bernhard, 97509 Kolitzheim (DE)
(74) Vertreter: FDST Patentanwälte

(56) Entgegenhaltungen:
- EP-A2- 2 086 020
- DE-A1-102008 050 765

## Beschreibung

Die Erfindung bezieht sich auf eine Photovoltaikanlage mit einer Mehrzahl von Photovoltaik-Modulen, die elektrisch zu einem Photovoltaik-Generator verbunden sind, dessen erstes Strangende einen Minuspol bildet und dessen zweites Strangende einen Pluspol bildet. Der Photovoltaik-Generator umfasst dabei eine Zahl von Photovoltaik-Modulen, die zu mindestens einem Strang verbunden sind. Es können auch mehrere parallel geschaltete Stränge vorgesehen sein.

Anlagen dieser Art sind sattsam bekannt. In solchen Anlagen ist eine Anzahl von z.B. zehn Photovoltaik-Modulen in Reihe geschaltet. Die Module bilden dabei einen sogenannten Strang. Jedes Photovoltaik-Modul umfasst wiederum z. B. 100 Photovoltaikzellen, die ihrerseits elektrisch in Reihe geschaltet sind. Eine einzelne zurzeit gebräuchliche Halbleiter - Photovoltaikzelle erzeugt bei Einstrahlung von Sonnenenergie eine Spannung von ca. 0,5 Volt, was eine Modulspannung von 50 Volt erzeugt. Im Ergebnis liegt dann je nach Einsatz der Anlage im Lastfall über den Strang eine Spannung, im folgenden Strangspannung genannt, von ca. 500 Volt vor. Im Leerlauffall ohne Last erhöht sich die Strangspannung auf ca. 800 Volt. Es ist üblich, eine Mehrzahl von Strängen, z.B. von 10 Strängen, durch Parallelschalten zu bündeln und dann die erzeugte Energie mittels einer gemeinsamen Sammelleitung zur weiteren Verwertung bereitzustellen.

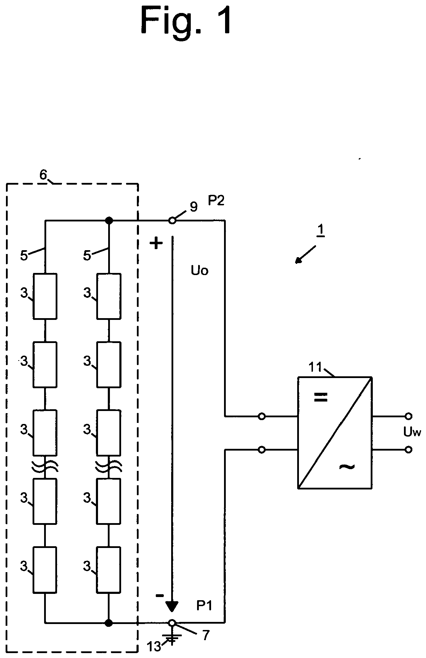

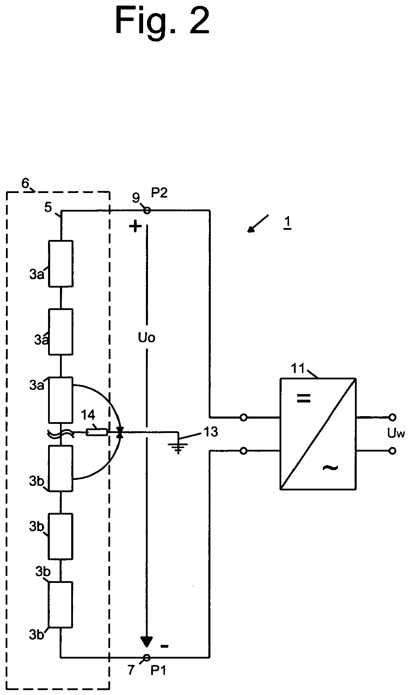

Die erzeugte elektrische Energie liegt in Form einer Gleichspannung vor. Sie wird mittels eines Wechselrichters in eine Wechselspannung wechselgerichtet. Dabei sind zurzeit die in den Figuren 1 und 2 beispielhaft gezeigten Schaltungen üblich. Gleiche Bauelemente sind jeweils mit denselben Bezugszeichen versehen.

Nach Fig. 1 umfasst eine Photovoltaikanlage 1 eine Anzahl von Photovoltaik-Elementen 3, die jeweils in Reihe geschaltet sind und hier zwei Stränge 5 bilden, die parallel zu einander geschaltet sind. Der so gebildete Photovoltaik-Generator 6 besitzt ein erstes und ein zweites Strangende 7, 9, die negatives bzw. positives Potential P1 bzw. P2 aufweisen. Das erste Strangende 7 ist der Minuspol des Photovoltaik-Generators 6 und besitzt damit das erste (niedere) Strangpotential P1, und das zweite Strangende 9 ist der Pluspol des Photovoltaik-Generators 6 und besitzt damit das zweite (höhere) Strangpotential P2. An die Strangenden 7, 9 ist ein Wechselrichter 11 angeschlossen. Die Spannung Uo zwischen den Strangenden 7, 9 beträgt zurzeit im Lastfall z. B. die erwähnten ca. 500 V und im Leerlauffall die erwähnten 800 Volt. Die Isolation der zu den Photovoltaikmodulen verlegten Kabel ist dabei auf einen Wert von ca. 1000 Volt ausgelegt, was ausreicht, um die zur Zeit gebräuchlichen Modultypen in dieser Variante sicher zu betreiben.

Die in Figur 2 gezeigte zweite Schaltung 1 umfasst, der einfachen Darstellung wegen, im Photovoltaik-Generator 6 nur einen Strang 5 aus in Reihe geschalteten Modulen 3. Diese Photovoltaikanlage 1 bringt einen Nachteil ins Spiel. Bei dem gezeigten sogenannten potentialfreien Betrieb der Photovoltaikanlage 1 liegt an jedem der beiden Strangenden 7, 9 betragsmäßig ungefähr die gleiche Spannung gegenüber Erde 13 an. Das positive Strangpotential P2 im Leerlauffall (Uo = 800V) beträgt am Beispiel betrachtet ca. + 400 Volt gegen Erde 13, und das negative Strangpotential P1 beträgt ca. - 400 Volt gegen Erde 13. Diese Spannungen gegenüber Erde 13 trotz potentialfreiem Betrieb kommen durch einen nicht zu vernachlässigenden relativ kleinen Leitwert (= Kehrwert des ohmschen Widerstands) der verhältnismäßig langen Verbindungsleitungen zwischen den Modulen 3 (Verdrahtung der Anlage 1) und der Zuleitungen zum Wechselrichter 11 zustande. In einer Ersatzschaltbilddarstellung ist der kleine Leitwert durch einen Widerstand 14 symbolisiert, der etwa der Mitte der Reihenschaltung 5 der Module 3 zur Erde 13 führt. Dadurch nehmen parasitäre Entladungen zur Erde 13 endlich große Ausmaße an, und es stellt sich im Leerlauffall o.g. Potentialverteilung + 400V, - 400V gegenüber Erde 13 ein, da sie für die Gesamtanlage 1 energetisch am günstigsten ist. Auch hier treten keine Probleme bei einer üblichen Verkabelung mit einer Isolationssicherheit von 1000 Volt auf.

Aus der DE 20 2006 008 936 U ist es bekannt, eine Konstantspannungsquelle vorzusehen, die den Minuspol der Photovoltaikanlage auf ein **positives Potential anhebt.** Diese gegenteilige Vorgehensweise erfolgt zu gänzlich anderen Zwecken: Es wird der Austritt von Elektronen aus der TCO-Schicht der Module 3 reduziert, so dass Kathodenentladungen verringert oder ganz vermieden werden, um eine Kathodenerosion am Modul zu verhindern.

Dieselbe Maßnahme ist aus der eigenen Anmeldung EP 2086020A2 bekannt. In der dort beschriebenen Vorrichtung zur **Potentialanhebung** ist noch eine Variante vorgesehen, der zufolge die Konstantspannungsquelle am Pluspol der Photovoltaikanlage angeschlossen ist, um diesen zur Reduzierung einer Blitz-Einschlagsgefahr auf ein höheres Potential zu heben. (Ohne der weiteren Entwicklung des Erfindungsgedankens vorgreifen zu wollen, sei hier bereits angemerkt, dass in beiden Dokumenten von einer **Potentialabsenkung** keine Rede ist und eine solche auch den dort gewünschten Zielen entgegenwirken würde).

Auf dem Photovoltaikgebiet sind zur Zeit technologische Veränderungen im Gange, die leistungsfähigere Module mit einer höheren Ausgangsspannung als die oben erwähnten 50 Volt für die Betriebsspannung (500 Volt über den Strang zu 10 Modulen) und 80 Volt für die Leerlaufspannung (800 Volt für die Strangleerlaufspannung) erzielen. Die Entwicklung auf der Wechselrichterseite geht einher, diese höheren Spannungen verarbeiten zu können. Der Hintergrund ist auch der Umstand, dass bei gleicher Leistung höhere Spannungen einen geringeren Strom mit sich bringen, was zugunsten der Kabelquerschnitte geht. Eine bestehende Verkabelung an einer existierenden Photovoltaikanlage könnte also auch nach einem Austausch von alten, z.B. gealterten Modulen gegen neue, moderne Module höherer Spannung weiter verwendet werden, wenn die Isolationserfordernisse erfüllt bleiben.

Entsprechend hat es sich die Erfindung zur Aufgabe gestellt, die Isolation einer Kabelverbindung und die der Photovoltaikmodule in einer Photovoltaikanlage dahin-gehend auszureizen, dass an dem Photovoltaik-Generator eine möglichst hohe Spannung erzeugt werden kann, ohne die zulässige Spannungsfestigkeit des Kabels zu überschreiten.

Diese Aufgabe wird erfindungsgemäß durch eine Vorrichtung zur Spannungsabsenkung gelöst, mittels der das Potential des Minuspols gegenüber Erde abgesenkt wird.

Diese Maßnahme hat den Vorteil, dass bei neu konzipierten Anlagen mit einer Leerlaufspannung über 1000 Volt bis hin zu maximal 2000 Volt weiterhin kostengünstige Kabel verwendet werden können, deren Isolation lediglich auf 1000 Volt ausgelegt ist. Der Isolationswert eines Kabels wie auch eines Photovoltaikmoduls ist immer in einer Spannungsfestigkeit gegenüber Erde angegeben. D.h. ein Modul oder Kabel mit einer maximalen Isolationsfestigkeit darf nur innerhalb dieses Maximalbereichs betrieben werden. Vorliegende Erfindung bietet den Vorteil, dass auch wenn durch Fortschritte bei der Herstellung von elektronischen Wechselrichtern die Anzahl der in Reihe geschalteten Module erhöht werden kann, was eine höhere Betriebs- und Leerlaufspannung mit sich bringt, das erfindungsgemäße Absenken des Potentials keine Verteuerung auf der Kabelseite nach sich ziehen wird, solange bei der Betriebsart nach der Figur 1 keine 1000 Volt Leerlaufspannung überschritten werden und bei der Betriebsart nach der Figur 2 keine 2000 Volt Leerlaufspannung überschritten werden.

Es folgt die Beschreibung eines erfindungsgemäßen Ausführungsbeispiels, wobei zunächst noch einmal auf den Stand der Technik eingegangen wird. Es zeigen:
- Figur 1: das Schema einer potentialgebundenen Photovoltaikanlage nach dem Stand der Technik,
- Figur 2: das Schema einer potentialfreien Photovoltaikanlage nach dem Stand der Technik,
- Figur 3: das Schema einer leistungsgesteigerten Photovoltaikanlage mit abgesenktem Potential,
- Figur 4a: einen Spannungsverlauf nach dem Stand der Technik und
- Figur 4b: einen Spannungsverlauf bei Potentialabsenkung.

Für gleiche Bauelemente werden dieselben Bezugszeichen verwendet.

Wie erwähnt, ist in den Figuren 1 und 2 das Schema einer potential-gebundenen bzw. potentialfreien Photovoltaikanlage (PV-Anlage) 1 dargestellt. Hierauf wurde im einleitenden Teil bereits kurz eingegangen. Die PV-Anlage 1 umfasst eine Anzahl von Photovoltaikmodulen 3, im Folgenden kurz Module genannt, die miteinander in Reihe geschaltet sind. Die Module 3 bilden gemeinsam einen Strang 5, der elektrisch ein erstes Strangende 7 aufweist, welches den Minuspol des PV-Generators 6 darstellt und an welchem ein negatives Strangpotential P1 anliegt. Es können mehrere Stränge 5 parallel geschaltet sein. Der Strang 7 hat ein zweites Strangende 9, an welchem ein positives Strangpotential P2 anliegt. Die zwischen den Strangenden 7, 9 anliegende Spannung ist mit Uo bezeichnet. An den Strangenden 7, 9 liegt ein potentialfreier Wechselrichter 11 an, der den von den Modulen 3 gelieferten Gleichstrom in Wechselstrom wandelt und z.B. zur Einspeisung in ein Versorgungsnetz (nicht gezeigt) zur Verfügung stellt. Der Begriff "potentialfrei" besagt hier, dass der Wechselrichter 11 erdpotentialfrei ist, also nicht an Erde 13 gebunden ist. Er hat damit weder eine positive noch negative Verbindung zur Erde 13.

Gemäß Figur 1 ist die Photovoltaikanlage 1 potentialgebunden betrieben, d.h. das negative Strangpotential P1 am ersten Strangende 7 ist auf Erdpotential 13 gelegt. Das positive Strangpotential P2 ist dann gleich der über die Stränge 5 anliegenden Spannung Uo und entspricht im Leerlauf z.B. 800 Volt. Die in Figur 2 gezeigte Photovoltaikanlage 1 zeigt dagegen den potentialfreien Betrieb einer Photovoltaikanlage 1. An jedem der beiden Strangenden 7, 9 liegt ungefähr die gleiche Spannung an. Das positive Strangpotential P2 beträgt am Beispiel betrachtet dann ca. + 400 Volt gegen Erde 13, und das negative Strangpotential P1 beträgt ca. -400 Volt gegen Erde 13. In der Anlage nach der Figur 2 mit schwebendem Potential besteht bei einer Erhöhung der Generatorspannung auf z.B. 1500 Volt die Gefahr, dass zum Beispiel durch einen Erdschluss an der Plus- oder Minusleitung die maximale zulässige Spannung zwischen Erde und dem betroffenen Bauteil von 1000 Volt um 500 Volt überschritten wird.

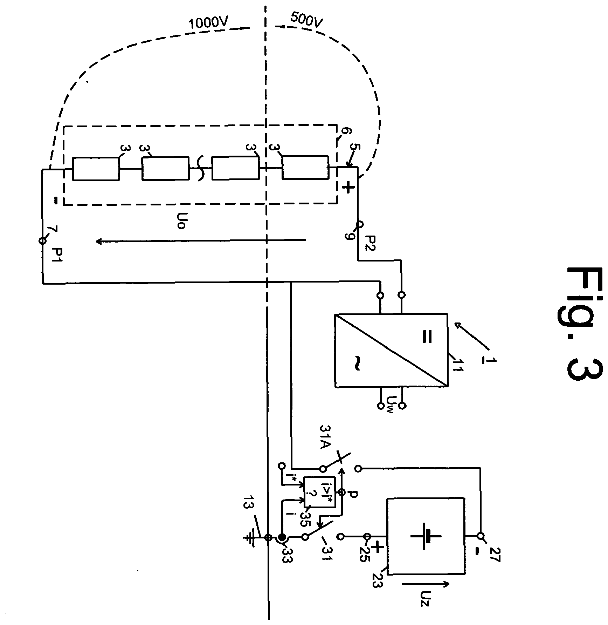

In der Figur 3 ist die Anlage der Figur 2 mit modernen Photovoltaikmodulen, die jeweils eine Leerlaufspannung von 150 Volt aufweisen, gezeigt. Desweiteren ist die Anzahl der Module 3 pro Strang 5 auf 10 erhöht, was zu einer Leerlaufspannung von 1500 Volt bei einer Betriebsspannung von 1000 Volt führt. Eine solche Anlage könnte weder mit den zur Zeit verwendeten Kabeln, die eine Isolationsfestigkeit von 1000 Volt haben, betrieben werden, noch dürften die Module, die nur auf eine Spannungsfestigkeit von 1000 Volt zugelassen sind verbaut werden. Bei einer neu errichteten Anlage müssten also teurere Kabel eingesetzt werden, oder bei einer geplanten Neubestückung einer bestehenden Anlage mit modernen Modulen wäre dieses nicht möglich. Hier schafft die Erfindung Abhilfe, indem, wie es in der Figur 3 gezeigt ist, neben den zuvor bezeichneten Bauteilen und Elementen 3 bis 13 eine Konstant-Gleich-Spannungsquelle 23 vorgesehen ist, die im Ausführungsbeispiel eine Spannung von z. B. Uz = 1000 Volt liefert und einen Plus-Anschlusspol 27 und einen Minus-Anschlusspol 25 besitzt. Dadurch dass die Spannungsquelle 23 eine Konstant-Spannungsquelle mit vorgegebener Spannung (Uz) ist, ergibt sich der Vorteil, dass aufgrund des theoretisch unendlich hohen Innenwiderstands der Spannungsquelle die Eigenschaft der potentialfreien Variante erhalten bleibt

Der Plus-Anschlusspol 27 ist dabei auf Erdpotential gelegt, wodurch das Potential P1 am ersten, negativen Strangspannungsende 7 auf -1000 Volt fixiert ist und das positive Strangpotential P2 frei floatet. Oder, anders ausgedrückt, das negative Strangpotential P1 am ersten Strangende 7 ist auf -1000 Volt vorgespannt. Zieht man die über den Strang 5 anliegende Spannung Uz von 1500 Volt von diesen -1000 Volt ab, so ergibt sich ein Strangpotential P2 am zweiten, positiven Strangende 9 von plus 500 Volt im Leerlauffall und von null Volt im Lastfall. Diese Werte liegen unterhalb der kritischen Isolationsfestigkeit der zurzeit verwendeten Verkabelung der PV-Anlage, so dass die Möglichkeit einer deutlich erhöhten Leistungsübertragung des Photovoltaik-Generators 6 bei günstigen Kabeln gegeben ist.

Ebenso können Photovoltaikmodule mit bezüglich der Spannungsfestigkeit unveränderter Bauart verwendet werden.

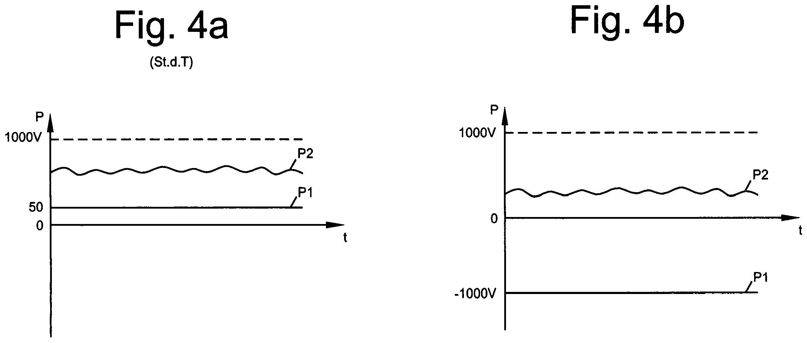

In der Figur 4a ist das Potential P(t) des Photovoltaik-Generators 6 über die Zeit aufgetragen, wie er sich beim Stand der Technik nach der DE 20 2006 008 936 U ergibt. Eine mit ihrem Minuspol geerdete Konstantspannungsquelle hebt das negative Potential P1 des Photovoltaikgenerators 6 auf plus 50 Volt, von wo aus die Betriebs- und die Leerlaufspannung frei nach oben floaten kann. Würde hier der PV-Generator 6 nach der Figur 3 eingesetzt werden, würde sich eine Leerlaufspannung U (P2 - P1) von 1550 Volt (50 Volt Vorspannung + 1500 Volt Leerlaufspannung) gegenüber Erde ergeben, die die Isolation der zurzeit üblichen Verkabelung und der Module überfordert und unzulässig ist.

Anders ist der Verlauf nach der Figur 4b bei Einsatz der Konstantspannungsquelle 23 mit ihrem geerdeten Pluspol. Das erste, negative Strangende 7 ist auf den Wert des Potentials der Spannungsquelle 23 von -1000 Volt fixiert. Ein negativeres Potential ist nicht möglich, da das positive Potential P2 des PV-Generators am zweiten Strangende 9 nur nach oben floaten kann, also immer größer ist, als das negative. Selbst bei der maximal möglichen Leerlaufspannung von 1500 Volt ergibt sich maximal ein Potential P2 von 500 Volt gegenüber Erde. So besteht immer noch ein Sicherheitsabstand von 500 Volt bis zur zulässigen Spannungsführung der Kabel oberhalb des Erdpotentials. Zur Dimensionierung der Konstant-Spannungsquelle 23 ist es zur Zeit sinnvoll, eine Spannung (Uz) zwischen 300 Volt und 1500 Volt, insbesondere zwischen 500 Volt und 1300 Volt, innerhalb dieses Bereichs wiederum bevorzugt zwischen 700 Volt und 1100 Volt und schließlich in Anlehnung an die zur Zeit verbauten Kabelsätze zwischen 950 Volt und 1050 Volt anzustreben. Die oben angegebenen Spannungsbereiche sind in Hinblick auf die zurzeit technologisch absehbare Entwicklung zu sehen. Sollten in Zukunft PV-Anlagen im Mittelspannungsbereich von mehreren Tausend Volt möglich sein, bleiben die Vorteile der obigen Potentialabsenkung analog erhalten, wenn eine Konstantspannungsquelle 23 mit entsprechend hoher Mittelspannung eingesetzt wird.

Es versteht sich von selbst, dass bei vorliegender Spannungsabsenkung keine Dünnschichtmodule mit TCO - Schicht verwendet werden können, die aufgrund von Kathodenerosion nur eine sehr reduzierte Lebensdauer hätten.

Die in Fig. 3 dargestellte Anlage 1 beinhaltet auch Mittel zum Personenschutz in Form eines Schutzschalters 31 oder eines alternativen Schutzschalters 31A. Damit ist eine Person bei Berührung eines Teils der Anlage 1 geschützt. Der Schalter 31 bzw. 31A ist so angebracht, dass er beim Erreichen eines vorgegebenen Stromgrenzwerts i* die Konstantspannungsquelle 23 wegschaltet. D. h. fortan fließt kein Strom i mehr durch den Körper der gefährdeten Person. Der Stromwert i* für den maximal zulässigen Fehlerstrom i kann z. B. 20 mA betragen. Natürlich kann auch zusätzlich ein Alarmsignal a abgegeben werden.

Mit anderen Worten: Es ist zur Vermeidung der Gefährdung von Personen ein Schutzschalter 31 - oder alternativ ein Schutzschalter 31A - eingesetzt. Er dient dazu, an irgendeiner Stelle die Verbindung zwischen Erde 13 und dem einen Pol 27 der Gleich-spannungsquelle 23 abzutrennen. Er hat die Funktion eines FI-Schutzschalters. Vorliegend wird jedoch nicht ein solcher Fehlerstrom-Schalter eingesetzt. Vielmehr liegt in der Leitung ein Sensor oder Strommessglied 33, das den Strom i misst und einen entsprechenden Messwert einem Vergleichsglied 35 zuführt. Dieses ist mit einem vorgegebenen Strom-Grenzwert i* beaufschlagt. Übersteigt der Stromwert i den Grenzwert i*, so wird ein Abschaltsignal p abgegeben, das zum Abschalten des Schalters 31 bzw. 31A führt. Dieses Abschaltsignal p kann gleichzeitig auch als Alarmsignal a dienen, um den gefährlichen Zustand der Anlage 1 oder die Gefährdung einer Person anzuzeigen.

### Bezugszeichenliste

- 1: Photovoltaikanlage
- 3, 3a, 3b: Photovoltaikmodul
- 5: Strang
- 6: Photovoltaik-Generator
- 7: 1. Strangende, negativ
- 9: 2. Strangende, positiv
- 11: Wechselrichter
- 13: Erdpotential
- 23: Konstantspannungsquelle
- 25: Minus-Anschlusspol
- 27: Plus-Anschlusspol
- 31: Schutzschalter
- 31A: alternativer Schutzschalter
- 33: Strommessglied oder-sensor
- 35: Vergleichsglied
- 37: Strommessgerät
- P1: negatives Strangpotential
- P2: positives Strangspotential
- Uo: Spannung des PV-Generators 6
- Uz: Zusatzspannung
- i: Strom
- p: Abschaltsignal
- i*: maximal zulässiger Strom
- a: Alarmsignal

## Patentansprüche

1. Photovoltaikanlage (1) mit einer Mehrzahl von Photovoltaik-Modulen (3), die elektrisch zu mindestens einem Strang (5) verbunden sind und so einen Photovoltaik-Generator (6) bilden, dessen erstes Strangende (7) einen Minuspol bildet und dessen zweites Strangende (9) einen Pluspol bildet,
**gekennzeichnet durch** eine Vorrichtung (23) zur Spannungsabsenkung, mittels der das Potential (P1) des Minuspols gegenüber Erde (13) abgesenkt wird wobei die Vorrichtung (23) eine Spannungsquelle mit einem Minus-Anschlusspol (27) und einem Plus-Anschlusspol (29) ist, und
wobei der Plus-Anschlusspol (27) auf Erdpotential (13) gelegt ist und der Minus-Anschlusspol (29) elektrisch mit dem Minuspol des Photovoltaik-Generators (6) verbunden ist.

2. Photovoltaikanlage (1) nach Anspruch 1, **dadurch gekennzeichnet, dass** die Spannungsquelle (23) eine Konstant-Spannungsquelle mit vorgegebener Spannung (Uz) ist.

3. Photovoltaikanlage (1) nach einem der Ansprüche 1 bis 2, **dadurch gekennzeichnet, dass** das erste und das zweite Strangende (7, 9) des Photovoltaik-Generators (6) an einen potentialfreien Wechselrichter (11) angeschlossen sind.

4. Photovoltaikanlage (1) nach Anspruch 2 oder 3, **dadurch gekennzeichnet, dass** die Konstant-Spannungsquelle (23) eine Spannung (Uz) zwischen 100 Volt und 1500 Volt bereitstellt.

5. Photovoltaikanlage (1) nach Anspruch 4, **dadurch gekennzeichnet, dass** die Konstant-Spannungsquelle (23) eine Spannung (Uz) zwischen 500 Volt und 1500 Volt bereitstellt.

6. Photovoltaikanlage (1) nach Anspruch 5, **dadurch gekennzeichnet, dass** die Konstant-Spannungsquelle (23) eine Spannung (Uz) von ca. 1000 Volt, insbesondere zwischen 950 Volt und 1050 Volt, bereitstellt.

7. Photovoltaikanlage (1) nach einem der Ansprüche 1 bis 6, **gekennzeichnet durch** einen Schalter (31, 31A), der bei einem zwischen dem Photovoltaik-Generator (6) und Erdpotential (13) detektierten Strom (i) oberhalb eines vorgegebenen Strom-Grenzwerts (i*) die Spannungsquelle (23) von der Photovoltaikanlage (1) abtrennt oder die Spannungsquelle (23) vom Erdpotential (13) trennt.

8. Photovoltaikanlage (1) nach Anspruch 7, **gekennzeichnet durch** eine Vergleichsschaltung (35), der der Strom-Grenzwert (i*) vorgegeben ist und die mit einem Strommessglied (33) in einer Leitung von oder zu der Spannungsquelle (23) verbunden ist.

9. Photovoltaikanlage nach Anspruch 7 oder 8, **dadurch gekennzeichnet, dass** ein Warnsignal erzeugt wird, wenn der detektierte Strom (i) oberhalb eines vorgegebenen Strom-Grenzwerts (i*) liegt.

## Claims

1. Photovoltaic system (1) with a plurality of photovoltaic modules (3), which are electrically connected to form at least one string (5) and thus form a photovoltaic generator (6), the first string end (7) of which forms a negative pole and the second string end (9) of which forms a positive pole,
**characterized by** a device (23) for voltage lowering, by means of which the potential (P1) of the negative pole is lowered versus ground (13), wherein the device (23) is a voltage source with a negative terminal pole (27) and a positive terminal pole (29), and
wherein the positive terminal pole (27) is applied to ground potential (13) and the negative terminal pole (29) is electrically connected to the negative pole of the photovoltaic generator (6).

2. Photovoltaic system (1) according to claim 1, **characterized in that** the voltage source (23) is a constant voltage source with a predetermined voltage (Uz).

3. Photovoltaic system (1) according to one of claims 1 to 2, **characterized in that** the first and second string ends (7, 9) of the photovoltaic generator (6) are connected to a potential-free inverter (11).

4. Photovoltaic system (1) according to claim 2 or 3, **characterized in that** the constant voltage source (23) provides a voltage (Uz) between 100 volts and 1500 volts.

5. Photovoltaic system (1) according to claim 4, **characterized in that** the constant voltage source (23) provides a voltage (Uz) between 500 volts and 1500 volts.

6. Photovoltaic system (1) according to claim 5, **characterized in that** the constant voltage source (23) provides a voltage (Uz) of approximately 1000 volts, in particular between 950 volts and 1050 volts.

7. Photovoltaic system (1) according to one of claims 1 to 6, **characterized by** a switch (31, 31A), which, in the event of a detected current between the photovoltaic generator (6) and ground potential (13) (i) above a predetermined current limit value (i*), disconnects the voltage source (23) from the photovoltaic system (1) or separates the voltage source (23) from the ground potential (13).

8. Photovoltaic system (1) according to claim 7, **characterized by** a comparator circuit (35), for which the current limit value (i*) is predetermined and which is connected to a current measuring element (33) in a line from or to the voltage source (23).

9. Photovoltaic system according to claim 7 or 8, **characterized in that** a warning signal is generated when the detected current (i) is above a predetermined current limit value (i*).

## Revendications

1. Installation photovoltaïque (1) avec une pluralité de modules photovoltaïques (3), qui sont reliés électriquement pour former au moins un cordon (5) et ainsi un générateur photovoltaïque (6), dont la première extrémité de cordon (7) forme un pôle négatif et la deuxième extrémité de cordon (9) un pôle positif,
**caractérisée par** un dispositif (23) pour l'abaissement de la tension, au moyen duquel le potentiel (P1) du pôle négatif est abaissé par rapport à la terre (13), dans laquelle le dispositif (23) est une source de tension avec un pôle terminal négatif (27) et un pôle terminal positif (29), et
dans laquelle le pôle positif de la borne (27) est placé au potentiel de terre (13) et le pôle négatif de la borne (29) est relié électriquement au pôle négatif du générateur photovoltaïque (6).

2. Installation photovoltaïque (1) selon la revendication 1, **caractérisée en ce que** la source de tension (23) est une source de tension constante avec une tension prédéterminée (Uz).

3. installation photovoltaïque (1) selon l'une des revendications 1 à 2, **caractérisée en ce que** la première et la deuxième extrémité de cordon (7, 9) du générateur photovoltaïque (6) sont reliées à un inverseur sans potentiel (11).

4. Installation photovoltaïque (1) selon la revendication 2 ou 3, **caractérisée en ce que** la source de tension constante (23) fournit une tension (Uz) comprise entre 100 volts et 1500 volts.

5. Installation photovoltaïque (1) selon la revendication 4, **caractérisée en ce que** la source de tension constante (23) fournit une tension (Uz) comprise entre 500 volts et 1500 volts.

6. Installation photovoltaïque (1) selon la revendication 5, **caractérisée en ce que** la source de tension constante (23) fournit une tension (Uz) d'environ 1000 volts, notamment comprise entre 950 volts et 1050 volts.

7. Installation photovoltaïque (1) selon l'une des revendications 1 à 6, **caractérisée par** un commutateur (31, 31A) qui, en cas d'un courant détecté entre le générateur photovoltaïque (6) et le potentiel de terre (13) supérieur à une valeur limite de courant (i*) prédéterminée, le commutateur déconnecte la source de tension (23) de l'installation photovoltaïque (1) ou sépare la source de tension (23) du potentiel de terre (13).

8. Installation photovoltaïque (1) selon la revendication 7, **caractérisée par** un circuit comparateur (35), auquel la valeur limite de courant (i*) est prédéterminée et qui est relié à un élément de mesure de courant (33) dans une ligne depuis ou vers la source de tension (23).

9. Installation photovoltaïque selon la revendication 7 ou 8, **caractérisée en ce qu'**un signal d'avertissement est généré lorsque le courant détecté (i) est supérieur à une valeur limite de courant (i*) prédéterminée.
